**Europäisches Patentamt**

**European Patent Office**

**Office européen des brevets**

(19)

(11) Veröffentlichungsnummer : **0 173 991 B2**

# (12) NEUE EUROPÄISCHE PATENTSCHRIFT

(45) Veröffentlichungstag der neuen Patentschrift :
**06.05.92 Patentblatt 92/19**

(51) Int. Cl.$^5$ : **H01R 13/719**, H03H 1/00

(21) Anmeldenummer : **85111042.9**

(22) Anmeldetag : **02.09.85**

(54) **Gerätestecker mit integriertem elektrischen Entstörfilter.**

(30) Priorität : **04.09.84 DE 3432502**

(43) Veröffentlichungstag der Anmeldung :
**12.03.86 Patentblatt 86/11**

(45) Bekanntmachung des Hinweises auf die
Patenterteilung :
**02.12.87 Patentblatt 87/49**

(45) Bekanntmachung des Hinweises auf die
Entscheidung über den Einspruch :
**06.05.92 Patentblatt 92/19**

(84) Benannte Vertragsstaaten :
**BE CH DE FR GB IT LI SE**

(56) Entgegenhaltungen :
**EP-A- 0 025 195**
**EP-A- 0 113 465**
**CH-A- 520 447**
**CH-B- 557 583**
**DE-A- 1 911 779**
**DE-A- 3 304 915**
**DE-B- 2 103 069**
**DE-U- 6 601 390**
**GB-A- 820 687**
**US-A- 4 205 891**

(56) Entgegenhaltungen :
**Fa. Schaffner Elektronik AG, CH: Zeichnung
ZZ 3.28.1531, FN 322 Bestückt sowie Prüfbericht Prospekt.
EMC, Dieter Stoll ISBN 3-87087-069-9, Elitera
Verlag 1976, S.50
"Elektromagn. Verträdichkeit" Bd 41,
1983,ISBN 3-88508-932-7
"Elektronik Lexikon" Dr. Waltter Baier,1982,
ISBN 3-440-05026-2 S.527,528,373**

(73) Patentinhaber : **SIEMENS
AKTIENGESELLSCHAFT
Wittelsbacherplatz 2
W-8000 München 2 (DE)**

(72) Erfinder : **Dirmeyer, Josef, Dipl.-Ing. (FH)
Neuenschwand 64
W-8465 Bodenwöhr (DE)**
Erfinder : **Kathmann, Heinz
Spitzwegstrasse 48
W-8400 Regensburg (DE)**
Erfinder : **Merkle, Franz
Feldstrasse 5
W-8012 Ottobrunn (DE)**
Erfinder : **Oberberger, Franz
Kastnerstrasse 34
W-8401 Mötzing (DE)**
Erfinder : **Wilhelm, Walter, Dipl.-Ing. (FH)
Wasenstetter Weg 6
W-8411 Wenzenbach (DE)**
Erfinder : **Wimmer, Josef, Dipl.-Ing.
Ulmenstrasse 14
W-8413 Regenstauf (DE)**

EP 0 173 991 B2

## Beschreibung

Die Erfindung betrifft einen Gerätestecker mit einem zwischen die Netz- und Geräteanschlüsse des Gerätesteckers geschalteten, in den Gerätestecker integrierten elektrischen Entstörfilter mit auf den Gerätestecker aufgeschobenem und mit dem Schutzleiter, der über die gesamte Länge des Entstörfilters geführt ist, galvanisch verbundenen metallischen Filtergehäuse, an dessen zur Geräteseite gekehrter, mindestens teilweise offener Stirnseite die Geräteanschlüsse, insbesondere Flachstecker, Anschlußlitzen, Stiftstecker und dergleichen, herausgeführt sind.

Die Entstörfilter der vorstehend genannten Art sind unter anderem für den Einsatz in Tischrechnern, Büromaschinengeräten und medizinischen Geräten bestimmt. Ihre wesentliche Aufgabe besteht dabei in der Verminderung leitungsgebundener Störpegel. Da diese Filter bedingt durch ihre Verwendungsart durch ihre Einsatzumgebung hohen elektrischen und magnetischen Feldstärkepegeln ausgesetzt sind, ist darauf zu achten, daß ihre Entstörwirkung durch elektrische und magnetische Einkopplungen auf die Verdrahtung bzw. die Bauteile der Filterschaltung nicht gemindert wird. Insbesondere bei ihrem Einsatz in elektrischen Geräten mit Schaltnetzteilen und/oder Mikroprozessorsystemen mit ihren langen Busleitungen treten diese Probleme in hohem Maße auf. Soweit bereits Versuche unternommen wurden, um diese Probleme zu lösen, bestehen diese z.B. in der Verwendung allseitig geschlossener Metallgehäuse für die Entstörfilter, die isolierte Durchführungen für die Anschlüsse aufweisen. Als Metallgehäuse dienen dabei tiefgezogene Gehäuse aus Neusilber oder zweiteilige dicht verlötete Gehäuse aus Eisenblech.

Bekannt geworden sind solche Filter z.B. als Filter mit integriertem Kaltgerätestecker, bei denen die Anschlüsse von der Netzseite her über diesen Kaltgerätestecker - üblicherweise eine sogenannte Steckdose - und die Kontaktierung zum Gerät, das mit dem Filter zu versehen ist, über Flachstecker, Anschlußlitzen, Lötfahnen oder dergleichen erfolgen. Verwiesen sei hierzu beispielsweise auf die unter dem Titel "Elektromagnetische Verträglichkeit durch den Einsatz von Entstörfiltern" von Siemens herausgegebene technische Mitteilung aus dem Bereich Bauelemente, Bestell Nr. B/2418, insbesondere Seite 18 und auf den unter der Bestell Nr. B/2284 erhältlichen Siemens - Werbeprospekt "Funk-Entstörfilter", Lieferprogramm 1980/81 S. 12, 13.

In eine Halbschale aus Neusilberblech sind dabei die Anschlüsse und die Träger der elektrischen Bauelemente dicht eingeklebt. Die elektrischen Bauelemente an sich werden bei diesem Entstörfilter in der Halbschale montiert, isoliert und von Hand eingelötet. Anschließend werden die elektrischen Bauelemente von der offenen Seite der Halbschale her zuerst mit einem weichen Epoxidharzverguß fixiert und anschließend durch einen Hartverguß mechanisch geschützt.

Weitere, im Handel erhältliche Entstörfilter verwenden anstelle der Neusilber-Halbschale ein tiefgezogenes Neusilber-Gehäuse. Die Bauelemente werden dabei in einem Hilfsrahmen mit flachen Steckern montiert und gelötet. Das Vergießen der Bauelemente und der im Filtergehäuse befindlichen Flachsteckerteile erfolgt durch ein Loch im Neusilbergehäuse, das dicht durch beilegen von Dichtringen mit Stecker und Rahmen verbunden sein muß. Das Vergußloch ist durch ein aufgeklebtes Typenschild abgedeckt.

Gleichfalls im Handel erhältliche Entstörfilter benutzen ein gelötetes Mantelrohr aus Weißblech, wobei die elektrischen Bauelemente auf einer Trägerplatte montiert werden, die anschließend am Stecker angenietet wird. Das Anlöten des Masseanschlusses erfolgt durch ein Loch im Mantelrohr, das vorher auf den Stecker aufgeschoben werden muß. Die Lötstelle wird durch ein Typenschild abgedeckt. Der Verguß der elektrischen Bauelemente erfolgt dabei von der offenen Rückseite des Mantelrohres her.

Schließlich sind z.B. durch Siemens-Datenbuch 1983/84 "EMV Funk-Entstörung-Bauelemente, Filter", S. 240 Entstörfilter bekannt, die sich durch eine wirksame magnetische Schirmung und gute Hochfrequenzeigenschaften auszeichnen, mit verhältnismäßig geringem Aufwand herstellbar sind und die an diese Filter gestellten nationalen und internationalen Vorschriften erfüllen. Diese Filter besitzen ein Filtergehäuse mit in das Gehäuse eingesetzten und in Vergußmasse eingebetteten Induktivitäten und Kapazitäten, und elektrische Anschlüsse, insbesondere Flachstecker, Anschlußlitzen, Stiftstecker und dergleichen, die an offenen Stirnenden des Filtergehäuses herausgeführt und an die elektrischen Bauelemente angeschaltet sind. Das Filtergehäuse ist dabei derart verlängert, daß die nach außen gekehrten Anschlußelemente mindestens eines Anschlußes geschirmt innerhalb des Filtergehäuses angeordnet sind. Das Filtergehäuse kann zu diesem Zweck beispielsweise an seinen offenen Stirnenden schachtartig verjüngt sein.

Die Fertigung dieser Filter ist zwar bereits mit verhältnismäßig geringem Aufwand möglich; sie erfordert dennoch manuelle Tätigkeiten, so zum Teil auch nur manuell durchführbare Lötungen und aufwendige Wickelvorgänge.

Die vorliegende Erfindung hat sich daher die Aufgabe gestellt, einen Gerätestecker, insbesondere IEC-Stecker, mit Entstörfilter gemäß der eingangs genannten Art zu schaffen, der unter Beibehaltung der den letztgenannten bekannten Entstörfiltern eigenen guten HF- und Schirmeigenschaften, sowie unter Erfüllung der entsprechenden nationalen und internationalen Vorschriften auf äußerst kostengünstige, d.h. insbesondere

2

wenig aufwendige Weise herstellbar ist.

Diese Aufgabe wird durch die im Anspruch 1 angegebenen Merkmale gelöst.

Vereinfach wird die herstellung der vorstehenden Gerätestecker, wenn mehrere, jeweils mit den Schutzleiterteilen, mit den Netz- und mit den Geräteanschlüssen bestückte Isolierstoffplättchen über Isolierstoffstege zu einem Systemträger zusammengefaßt sind, derart, daß sämtliche Systeme jeweils in gemeinsamen Arbeitsgängen bearbeitbar sind.

Die Erfindung wird nachstehend anhand von Ausführungsbeispielen näher erläutert.

Es zeigt:

Fig. 1 in perspektivischer Darstellung ein Ausführungsbeispiel nach der Erfindung, wobei zur Veranschaulichung die kapazitiven Filterbauelemente, der Verguß dieser Anordnung in Form eines Gerätesteckers und das Filtergehäuse nicht gezeigt sind,

Fig. 2 in teils gebrochener Darstellung und Unteransicht die Anordnung nach Fig. 1,

Fig. 3 in perspektivischer Darstellung die in Form eines Gerätesteckers mit Kunststoff umhüllte Anordnung nach Fig. 1 und 2,

Fig. 4 in perspektivischer Darstellung ein Filtergehäuse, das zum Aufstecken auf den Gerätestecker nach Fig. 3 geeignet ist,

Fig. 5 in teils geschnittener Ansicht eine als Filterbauelement bestimmte, in einen Isolierstoffbehälter eingesetzte Ringkerndrossel.

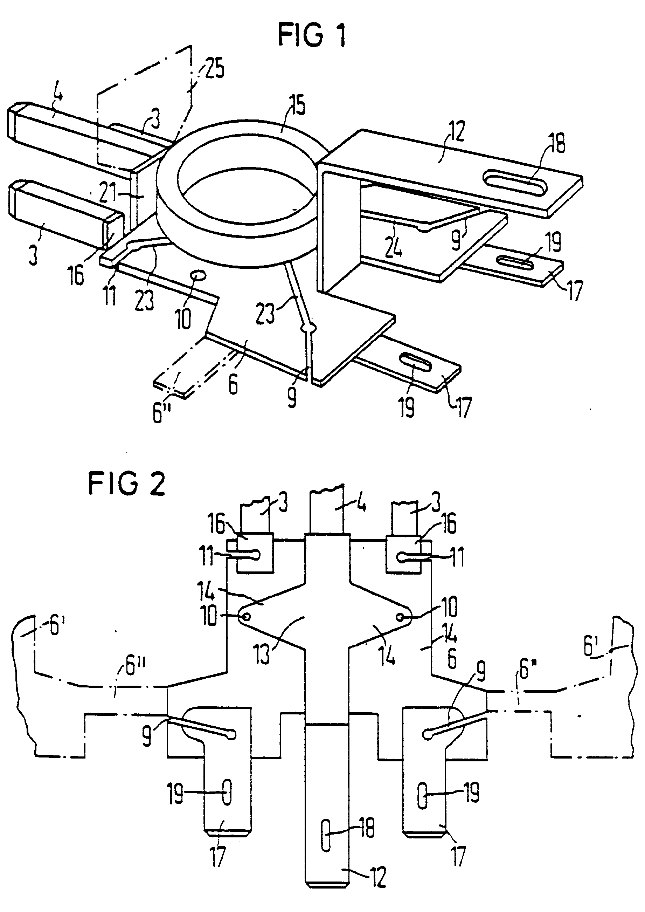

Die Fig. 1 zeigt als Teil eines Gerätesteckers stiftförmige elektrische Anschlußelemente 3, einen Schutzleiter 4 und ein nachgeschaltetes elektrisches Entstörfilter, von dessen elektrischen Filterbauelementen lediglich eine Ringkerndrossel 15 schematisch dargestellt ist. Das Entstörfilter ist zusätzlich mit einem zwischen die Anschlußelemente 3 geschalteten X- und mit zwei jeweils von den geräteseitigen elektrischen Anschlüssen 17 gegen den Schutzleiter geschalteten Y-Kondensatoren bestückt. Nachstehend sind lediglich die Kontaktierungen dieser Elemente mit den Anschlüssen erläutert.

Mit 6 ist ein Isolierstoffplättchen bezeichnet, auf dessen einer Seite die elektrischen Filterbauelemente angeordnet sind und auf dessen anderer Seite ein breitflächiger und in diesem Bereich als kreuzförmiges Schutzleiterteil 13 gestalteter Schutzleiter vorgesehen ist. Das Schutzleiterteil 13 ist mit seinem einen abgewinkelten Ende 21 mit dem Schutzleiter 4 kontaktiert. Das hierzu gegenüberliegende, gleichfalls abgewinkelte Ende 12 des Schutzleiterteils 13 ist - wie später erläutert wird mit dem auf den fertigen Gerätestecker aufgeschobenen Filtergehäuse 30 elektrisch leitend verbunden.

Auf der Seite des Schutzleiterteils 13 liegen zusätzliche, abgewinkelte Anschlußelemente 16 mit ihren einen Schenkeln auf, die mit ihren anderen Schenkeln mit den Stirnenden der elektrischen Anschlüsse 3 kontaktiert sind. Diese bereits genannten geräteseitigen Anschlüsse liegen auf der Seite des Schutzleiterteils 13 teils auf dem Isolierstoffplättchen 6 auf. Zur Kontaktierung z.B. mit Drähten, sind die Anschlüsse 17, und das Teil 12 des Schutzleiters zusätzlich mit Langlöchern 18 bzw. 19 ausgebildet.

Zur erleichterten Kontaktierung der netzseitigen und der geräteseitigen elektrischen Anschlüsse und des Schutzleiters mit den elektrischen Filterbauelementen sind die entsprechenden Teile der Anschlüsse 16, 17 die Enden 14 des kreuzförmigen Schutzleiterteils 13 und das Isolierstoffplättchen 6 teils mit Bohrungen 10 und teils mit randoffenen Schlitzen 9, 11 ausgestattet, die an ihren geschlossenen Enden zu Bohrungen erweitert sein können. Die Einführung der bevorzugt drahtförmigen Anschlußelemente der Wickelenden 23, 24 der Ringkerndrossel 15 und der nicht dagestellten X- und Y-Kondensatoren wird durch eine trichterförmige Gestaltung der Bohrungen erleichtert.

Im fertigmontierten Zustand der elektrischen Filterbauelemente sind die Wickelenden 23, 24 der Ringkerndrossel 15 über die Schlitze 9 bzw. 11 zu den Anschlüssen 17 bzw. zu den Elementen 16 geführt, der X-Kondensator mit seinen Anschlüssen auf die zu Bohrungen erweiterten Enden der Schlitze 11 aufgesteckt und die Y-Kondensatoren von den Bohrungen 10 der Anschlüsse 17 zu den Bohrungen 10 des Schutzleiterteils 13 geführt. Durch Tauchlöten läßt sich dabei die Kontaktierung in einem einzigen Arbeitsgang durchführen.

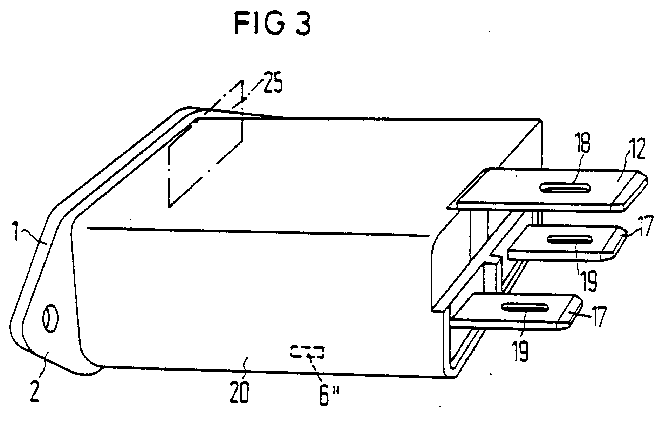

Die Anordnung nach Fig. 1 wird, wie dies in Fig. 3 gezeigt ist, mit Kunststoff 20, z.B. thermo- oder duroplatischem Kunststoff umhüllt, z.B. umspritzt oder umpreßt, derart, daß diese Anordnung die Form eines Gerätesteckers 1 mit durchbrochenen Laschen 2 erhält. Es erübrigen sich folglich zusätzliche Isolierstoffteile an den Enden des Entstörfilters. Darüberhinaus ist diese Art der Gerätesteckerausbildung äußerst wenig raumaufwendig und fertigungstechnisch erheblich vereinfacht herstellbar, und insbesondere, wenn mehrere, jeweils mit den Schutzleiterteilen 13, mit dem Netz und den Geräteanschlüssen bestückte Isolierstoffplättchen 6, 6 gemäß Darstellung nach Fig. 1, 2 über Isolierstege 6″ zu einem Systemträger zusammengefaßt sind, derart, daß sämtliche Systeme jeweils in gemeinsamen Arbeitsgängen bearbeitbar und schließlich voneinander trennbar sind.

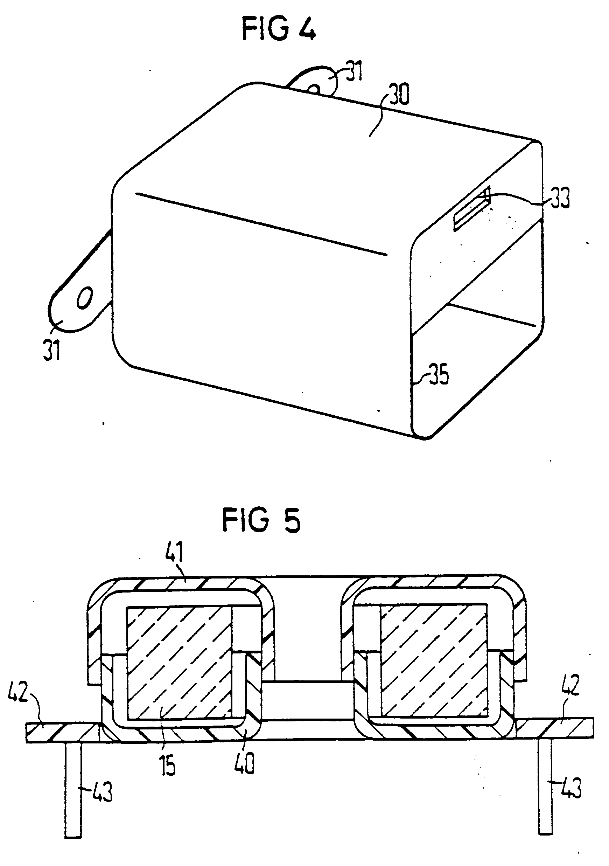

Auf dieses in Fig. 3 perspektivisch dargestellte Teil wird schließlich das mit durchbrochenen Laschen 31 ausgebildete Filtergehäuse 30 nach Fig. 4 aufgesteckt, das bevorzugt aus Aluminium gezogen ist. Die freien Enden der Anschlüsse 17 sind dabei durch die Öffnung 35 im Filtergehäuse und der Teil 12 des Schutzleiters durch einen Schlitz 33 im Filtergehäuse nach außen geführt. Das Filtergehäuse 30, das im aufgesteckten Zustand mit seinen Laschen 31 gegen die Laschen 2 des Gerätesteckers 1 anliegt ist mittels durch die Bohrungen geführten Schrauben mit diesem verschraubt, und im fertigmontierten Zustand der gesamten Anordnung mit dem Schutzleiter z.B. mittels Ultraschallschweißen galvanisch verbunden.

Anstelle der gezeigten Flachsteckeranschlüsse 12 bzw. 17 sind auch Stiftstecker und Anschlußlitzen möglich, die mittels Tauchlöten mit einem Schutzleiterteil bzw. mit Teilen der elektrischen Anschlüsse 17 kontaktiert sind.

Anstelle der vorerwähnten Kontaktierung des Schutzleiters mit dem Filtergehäuse 30, kann an den Schutzleiter z.B. an das netzseitige Schutzleiterteil 4, ein metallisches Plättchen 25, insbesondere Kupfer- Beryllium-Blech angelötet, angeschweißt oder z.B. angenietet sein, das mit einem z.B. in Fig. 3 schraffiert angedeuteten Teil über die Oberfläche der Kunststoffumhüllung 20 hinausragt und federnd gegen die Innenfläche des auf den Gerätestecker 1 aufgeschobenen Filtergehäuses 30 anliegt. Die vorstehend beschriebenen Kontaktierung des Schutzleiters mit dem Filtergehäuse mittels Ultraschallschweißen entfällt dadurch.

Die Fig. 5 zeigt schließlich eine nur mit geringem Aufwand verbundene Möglichkeit zur getrennten Bewicklung der Ringkerndrossel 15, die anschließend auf die Isolierstoffplatte 6 aufsteckbar und mittels Tauchlöten mit den entsprechenden Anschlüssen elektrisch kontaktierbar ist. Es erübrigen sich hierdurch die Bohrungen und Schlitze und folglich das bei der Ausführung nach Fig. 1 notwendige Einhängen der Wickelendenden in die Schlitze 9, 11. Die bereits bewickelte Ringkerndrossel 15 wird dabei in einen Isolierstoffbehälter eingesetzt, der aus zwei ineinandergesteckten kreisringförmigen Schalenhälften 40, 41 besteht. An die untere Schalenhälfte 40 sind Laschen 42 mit elektrischen Anschlußstiften 43 angeformt, an welche die Wickelenden beim abschließenden Wickelvorgang angewickelt werden.

## Patentansprüche

1. Gerätestecker mit einem zwischen die Netz- (3,4) und Geräteansfhlüsse (12,17) des Gerätesteckers geschalteten, in den Gerätestecker integrierten elektrischen Entstörfilter, mit auf den Gerätestecker aufgeschobenem und mit dem Schutzleiter (4,13,12), der über die gesamte Länge des Entstörfilters geführt ist, galvanisch verbundenen metallischen Filtergehäuse (30), an dessen zur Geräteseite gekehrter, mindestens teilweise offener Stirnseite die Geräteanschlüsse (12,17), insbesondere Flachstecker, Anschlußlitzen, Stiftstecker und dergleifhen, herausgeführt sind, **dadurch gekennzeichnet,** daß der Schutzleiter (4,13,12) breitflächig und im Bereich zwischen seinen Anschlüssen (4,12) als kreuzförmiges, als Träger eines Isolierstoffplättchens (6) dienendes Schutzleiterteil (13) gestaltet ist, dessen quer zur Schutzleiterlängsrichtung verlaufende Enden (14,14) mit Anschlußelementen von Y-Kondensatoren verbunden sind, daß das Isolierstoffplättchen (6) die durch dieses stefkbaren elektrischen Filterbauelemente (15) des Entstörfilters von dem Schutzleiterteil (13) trennt und daß die Netz- (3,4) und Geräteansfhlüsse (12,17) teilweise und das Schutzleiterteil (13) samt Isolierstoffplättchen (6) und Filterbauelementen (15) in Form eines Gerätesteckers mit Kunststoff (1,20) umhüllt sind.

2. Gerätestecker nach Anspruch 1, dadurch gekennzeichnet, daß das Isolierstoffplättchen (6) auf der Seite des Schutzleiterteils (13) zusätzlich die Netz- und Geräteanschlüsse (3, 4 bzw. 17, 12) trägt.

3. Gerätestecker nach Anspruch 1, dadurch gekennzeichnet, daß das Isolierstoffplättchen (6) mit Bohrungen (10) und randoffenen Schlitzen (9, 11) ausgebildet ist, die zum Schutzleiterteil (13) bzw. zu den elektrischen Anschlußelementen (16,17) auf dem Isolierstoffplättchen führen.

4. Gerätestecker nach Anspruch 1, dadurch gekennzeichnet, daß als induktives Filterbauelement eine Ringkerndrossel (15) vorgesehen ist, die in einem Isolierstoffbehälter, bestehend aus zwei ineinandergesteckten kreisringförmigen Schalenhälften (40, 41), eingesetzt ist, und daß an die untere Schalenhälfte (40) Laschen (42) mit elektrischen Anschlußstiften (43) angeformt sind, die auf das Isolierstoffplättchen (6) aufsteckbar sind.

5. Gerätestecker nach Anspruch 1, dadurch gekennzeichnet, daß der Schutzleiter mit seinem geräteseitigen Ende (12) mittels Ultraschallschweißen mit dem Filtergehäuse (30) galvanisch verbunden ist.

6. Gerätestecker nach Anspruch 1, dadurch gekennzeichnet, daß der Schutzleiter mit einem metallischen Plättchen (25), insbesondere Kupfer-Beryllium-Blech, elektrisch leitend verbunden ist, das mit einem Teil über die Oberfläche der Kunststoffumhüllung (20) hinausragt und federnd gegen die Innenseite des auf den Gerätestecker (1) aufgeschobenen Filtergehäuses (30) anliegt.

7. Gerätestecker nach einem der Ansprüche 1 bis 6, dadurch gekennzeichnet, daß mehrere, jeweils mit den Schutzleiterteilen (13) mit den Netz- (3,4) und mit den Geräteanschlüssen (12, 17) bestückte Isolierstoffplättchen (6, 6') über Isolierstoffstege (6'') zu einem Systemträger zusammengefaßt sind, derart, daß sämtliche Systeme jeweils in gemeinsamen Arbeitsgängen bearbeitbar und abschließend voneinander trennbar sind.

## Claims

1. Appliance plug having an electrical interference suppression filter connected between its mains terminal contacts (3, 4) and appliance terminal contacts (12, 17), integrated into the appliance plug, comprising a metallic filter housing (30) pushed onto the appliance plug and electrically connected to the earthed conductor (4, 13, 12) which extends along the entire length of the interference suppression filter, and the appliance terminal contacts (12, 17), in particular flat plugs, pigtails, pin plugs and the like, being led out at the end face of the filter housing facing the appliance and at least partially open, characterised in that the earthed conductor (4, 13, 12) is laminar and in the region between its terminal contacts (4, 12) consists of a cross-shaped earthed conductor component (13) serving to carry a plate (6) of insulating material, the ends of which (14, 14) running perpendicularly to the longitudinal direction of the earthed conductor are connected to connecting elements of Y-capacitors, in that the plate (6) of insulating material separates the electric filter components (15) of the interference filter, which may be plugged through this plate, from the earthed conductor component (13), and in that the mains terminal contacts (3, 4) and the appliance terminal contacts (12, 17) in part, and the earthed conductor component (13) together with the plate (6) of insulating material and filter components (15) are encased in plastic (1, 20) in the form of an appliance plug.

2. Appliance plug according to Claim 1, characterised in that, on the side of the earthed conductor component (13), the plate (6) of insulating material additionally bears the mains terminal contacts and appliance terminal contacts (3, 4 and 17, 12 respectively).

3. Appliance plug according to Claim 1, characterised in that the plate (6) of insulating material is provided with bores (10) and slots (9, 11) open at their edge, which lead to the earthed conductor component (13) and to the electric terminal contact elements (16, 17) on the plate of insulating material respectively.

4. Appliance plug according to Claim 1, characterised in that the inductive filter component consists of an annular-cored choke (15) inserted in a container for insulating material, composed of two annular half-shells (40, 41) fitted into one another, and in that lugs (42) with electric connecting pins (43) are moulded onto the lower half-shell (40), which pins can be placed onto the plate (6) of insulating material.

5. Appliance plug according to Claim 1, characterised in that at its end (12) facing the appliance, the earthed conductor is electrically connected to the filter housing (30) by ultrasonic welding.

6. Appliance plug according to Claim 1, characterised in that the earthed conductor is electrically conductively connected to a metallic plate (25), in particular a copper-beryllium plate, one part of which projects beyond the surface of the plastic casing (20) and flexibly contacts the inside of the filter housing (30) pushed onto the appliance plug (1).

7. Appliance plug according to Claims 1 to 6, characterised in that a plurality of plates (6, 6′) of insulating material, each equipped with the earthed conductor components (13), the mains terminal contacts (3, 4) and the appliance terminal contacts (12, 17), are combined by ribs of insulating material (6″) to form a system carrier, such that all the systems can in each case be processed in common operating steps and can then be separated from one another.

## Revendications

1. Socle connecteur d'appareil comportant un filtre électrique d'antiparasitage branché entre les bornes (3,4) de raccordement au réseau et les bornes (12,17) de raccordement de l'appareil, que comporte le socle connecteur, et intégré dans ce dernier et comportant un capot métallique de filtre (30), qui est emmanché sur le socle connecteur et est relié galvaniquement au ,conducteur de protection (4,13,12), qui s'étend sur toute la longueur du filtre d'antiparasitage, les bornes (12,17) de raccordement à l'appareil, notamment des fiches plaies, des torons de raccordement, des connecteurs à broches et autres, étant ressorties sur la face frontale au moins partiellement ouverte, tournée vers le côté de raccordement de l'appareil, caractérisé par le fait que le conducteur de protection (4,13,12) est conformé avec une surface large et, dans la zone située entre les bornes (4, 12), est agencé de préférence sous la forme d'un élément cruciforme (13), qui est utilisé en tant que support d'une plaquette en matériau isolant (6) et dont les extrémités (14,14), qui s'étendent transversalement par rapport à la direction longitudinale du conducteur de protection, sont reliées à des organes de raccordement de condensateurs en Y, que la plaquette en matériau isolant (6) sépare les composants électriques (15) du filtre d'antiparasitage, qui peuvent être enfichées dans cette plaquette, de l'élément (13) du conducteur de protection, et qu'une matière plastique (1,20) enveloppe les bornes (3,4) de raccordement du réseau et les bornes (12,17) de raccordement de l'appareil partiellement et l'élément (13) du conducteur de protection ainsi que la plaquette en matériau isolant (6) et des composants (15) du filtre sous la forme d'un socle connecteur.

2. Socle connecteur suivant les revendications 1, caractérisé par le fait que la plaque en matériau isolant (6) porte en outre, du côté de l'élément (13) du conducteur de protection, les bornes de raccordement au réseau et de raccordement à l'appareil (3,4 et 17,12).

3. Socle connecteur suivant la revendication 1, caractérisé par le fait que la plaquette en matériau isolant (6) est munie de perçages (10) et de fentes s'ouvrant latéralement (9,11), qui aboutissent à l'élément (13) du conducteur de protection ou aux organes électriques de raccordement (16,17) sur la plaquette en matériau isolant.

4. Socle connecteur suivant la revendication 1, caractérisé par le fait qu'il est prévu, comme composant de filtre inductif, une bobine d'arrêt à noyau toroïdal (15), qui est insérée dans un boîtier en matériau isolant constitué par deux moitiés de coque (40,41) en forme d'anneaux circulaires, imbriquées l'une dans l'autre, et que sur la moitié de la coque inférieure (40) se trouvent formées par façonnage des pattes (42) comportant des broches électriques de raccordement (43), qui peuvent être enfichées dans la plaquette en matériau isolant (6).

5. Socle connecteur suivant la revendication 1, caractérisé par le fait que, sur son extrémité (12) tournée vers l'appareil, le conducteur de protection est relié galvaniquement, au moyen d'une soudure réalisée aux ultrasons, au boîtier de filtre (30).

6. Socle connecteur suivant la revendication 1, caractérisé par le fait que le conducteur de protection est relié d'une manière électriquement conductrice à une plaquette métallique (25), notamment une tôle en cuivre-béryllium, dont un élément fait saillie au-delà de la surface de l'enveloppe en matière plastique (20) et s'applique élastiquement contre la face intérieure du boîtier de filtre (30) emmanché sur le socle connecteur (1).

7. Socle connecteur suivant les revendications 1 à 6, caractérisé par le fait que plusieurs plaquettes en matériau isolant (6, 6'), qui sont reliées respectivement par les éléments (13) des conducteurs de protection aux bornes (3,4) de raccordement au réseau et aux bornes (12,17) de raccordement à l'appareil, sont réunies par l'intermédiaire de barrettes en matériau isolant (6″) de manière à former un support de systèmes, de sorte que tous les systèmes peuvent être élaborés respectivement au cours de phases communes de travail et peuvent être ensuite séparées les unes des autres.

# FIG 1

# FIG 2

# FIG 3

## FIG 4

## FIG 5